# EUROPEAN PATENT APPLICATION

(11) **EP 4 644 442 A1**
(43) Date of publication of application: **05.11.2025**
(21) Application number: 23912681.6
(22) Date of filing: 13.12.2023
(51) Int. Cl.: C08F 222/10, C08F 220/18, C08F 220/30, C08F 210/14, C08F 2/50, H10K 59/10

(54) **COMPOSITION FOR ORGANIC LIGHT-EMITTING ELEMENT ENCAPSULATION AND ORGANIC LIGHT-EMITTING DISPLAY DEVICE COMPRISING SAME**

(30) Priority: 30.12.2022 KR 20220190346
(71) Applicant: Solus Advanced Materials Co., Ltd., Iksan-si, Jeollabuk-do 54588 (KR)
(72) Inventor: NOH, Seungjoo, Yongin-si, Gyeonggi-do 16858 (KR); KONG, Yisung, Yongin-si, Gyeonggi-do 16858 (KR)
(74) Representative: Office Freylinger
(86) International application number: PCT/KR2023/020502
(87) International publication number: WO 2024/144006

(57) **Abstract**

The present invention relates to a composition for encapsulating an organic light-emitting element and an organic light-emitting diode display device including the same, and to a composition for encapsulating an organic light-emitting element, which secures the performance and life of an organic light-emitting element by effectively blocking external moisture or oxygen flowing into an organic light-emitting diode display device and has low dielectric constant characteristics to have excellent touch sensitivity of a touch panel, and an organic light-emitting diode display device including the organic light-emitting element.

## Description

### [Technical Field]

The present invention relates to a composition for encapsulating an organic light-emitting element and an organic light-emitting diode display device including the same, and more specifically, to a composition for encapsulating an organic light-emitting element, which secures the performance and life of an organic light-emitting element by effectively blocking external moisture or oxygen flowing into an organic light-emitting diode display device and has low dielectric constant characteristics to have excellent touch sensitivity of a touch panel, and an organic light-emitting diode display device including the same.

### [Background Art]

Organic layer materials, electrodes, etc. constituting an organic light-emitting element have a problem that their luminous characteristics and life deteriorate due to external moisture or oxygen. Accordingly, there is a need for a protective layer capable of protecting organic materials, electrodes, etc. Such a protective layer is usually formed in a stacked structure of one or more organic layers and inorganic layers in order to effectively block external moisture or oxygen.

Recently, many capacitive touch panels to which an organic light-emitting element is applied have been adopted. Such a capacitive touch panel detects touch by a change in capacitance when a conductor is in contact with the touch panel, and in the case of a high-dielectric constant material, when an external electric field is applied, polarization occurs a lot, which tends to reduce touch sensitivity. Accordingly, there is a demand for the development of a composition for encapsulating an organic layer, which has low dielectric constant characteristics to have excellent touch sensitivity of a touch panel and is used in a stacked structure.

### [Disclosure]

### [Technical Problem]

The present invention is directed to providing a composition for encapsulating an organic light-emitting element, which secures the performance and life of an organic light-emitting element by effectively blocking external moisture or oxygen flowing into an organic light-emitting diode display device and has low dielectric constant characteristics to have excellent touch sensitivity of a touch panel, and an organic light-emitting diode display device including the organic light-emitting element.

### [Technical Solution]

To solve the above problems, according to the present invention, there is provided a composition for encapsulating an organic light-emitting element including a photocurable monomer including all of monomers represented by the following Chemical Formulas 1 to 3, and a photopolymerization initiator, wherein a dielectric constant is 2.65 or less at a frequency in a range of 100 kHz to 1 MHz,

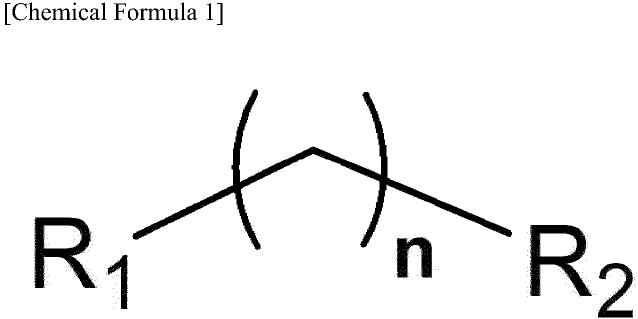

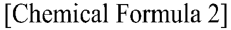

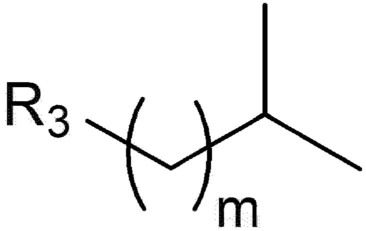

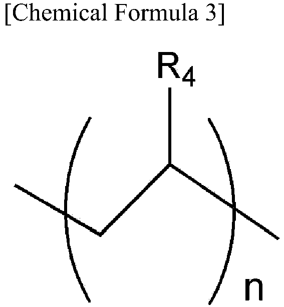

in Chemical Formulas 1 to 3,
R₁ to R₃ are, each independently, a (meth)acryloyl group,
R₄ is a substituted or unsubstituted C₁₋₂₀ alkyl group,
m ranges from 5 to 15, and
n ranges from 1 or 10.

Another organic light-emitting diode display device according to the present invention contains the composition for encapsulating an organic light-emitting element.

### [Advantageous Effects]

When the encapsulation part of the organic light-emitting diode display device is formed using the composition for encapsulating an organic light-emitting element, it is possible to secure the performance and life of the organic light-emitting element by effectively blocking moisture or oxygen introduced from the outside and have excellent touch sensitivity of the touch panel due to low dielectric constant characteristics.

### [Description of Drawings]

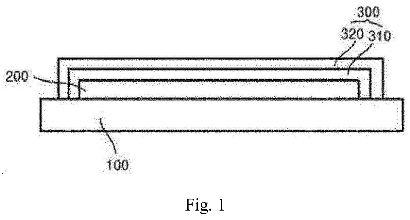

FIG. 1 is an exemplary view of an organic light-emitting diode display device according to one embodiment of the present invention.

### [Mode for Invention]

Hereinafter, embodiments of the present invention will be described in detail with reference to the accompanying drawings.

In adding reference numerals to components in each drawing, it should be noted that the same components are denoted as the same reference numerals as much as possible even when they are illustrated in different drawings. In addition, in describing embodiments of the present invention, when it is determined that the detailed description of related known configurations or functions may obscure the gist of the present invention, the detailed description thereof will be omitted.

When a certain component is described as being "connected," "coupled," or "joined" to another component, the component may be directly connected or joined to another component, but still another component may be "connected," "coupled," or "joined" between the components. In addition, when a component, such as a layer, a film, an area, a plate, or the like, is described as being "above" or "on" another component, it includes not only a case in which the component is "directly on" another component, but also a case in which still another component is disposed therebetween. Conversely, when a component is described as being "directly on" another component, it means that still another component does not exist therebetween.

The term "(meth)acryl" as used herein refers to acryl and/or methacryl.

The term "alkyl group" as used herein refers to a radical of a saturated aliphatic functional group that has 1 to 60 carbon atoms linked by a single bond and includes a straight-chain alkyl group, a branched-chain alkyl group, a cycloalkyl (alicyclic) group, an alkyl-substituted cycloalkyl group, and a cycloalkyl-substituted alkyl group unless otherwise stated.

The term "alkylene group" as used herein refers to an alkanediyl group linked to a saturated hydrocarbon without a double bond and refers to having two linking groups.

In addition, unless explicitly stated, "substituted" in the term "substituted or unsubstituted" used herein refers to being capable of being substituted with one or more substituents selected from the group consisting of deuterium, halogen, an amino group, a nitrile group, a nitro group, a C₁₋₂₀ alkyl group, a C₁₋₂₀ alkoxy group, a C₁₋₂₀ alkylamine group, a C₁₄₋₂₀ alkylthiophene group, a C₆₋₂₀ arylthiophene group, a C₂₋₂₀ alkenyl group, a C₂₋₂₀ alkynyl group, a C₃₋₂₀ cycloalkyl group, a C₆₋₂₀ aryl group, a C₆₋₂₀ aryl group substituted with deuterium, a C₈₋₂₀ arylalkenyl group, a silane group, a boron group, and a C₂₋₂₀ heterocyclic group containing at least one heteroatom selected from the group consisting of O, N, S, Si, and P, but is not necessarily limited to these substituents.

The term "dielectric constant" used herein refers to a value measured by an electric capacitance method for an organic layer including a composition for encapsulating an organic light-emitting element according to the present invention.

The term "viscosity" used herein refers to a value measured by a rotational viscometer for an organic layer including a composition for encapsulating an organic light-emitting element according to the present invention.

A composition for encapsulating an organic light-emitting element according to the present invention includes a photocurable monomer including all of monomers represented by the following Chemical Formulas 1 to 3, and a photopolymerization initiator and has a characteristic of a dielectric constant of 2.65 or less at a frequency in the range of 100 kHz to 1 MHz, and the viscosity of the composition may range from 10 to 20 cPs. 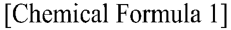 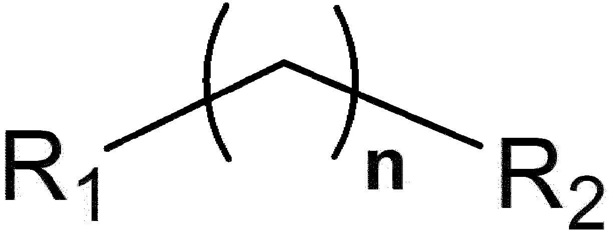 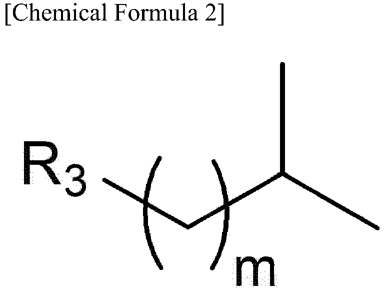 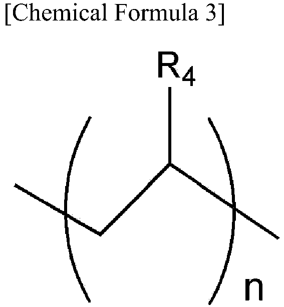 in Chemical Formulas 1 to 3,
R₁ to R₃ are, each independently, a (meth)acryloyl group,
R₄ is a substituted or unsubstituted C₁₋₂₀ alkyl group,
m ranges from 5 to 15, and
n ranges from 1 or 10.

The monomer represented by Chemical Formula 1 may be one or more selected from the group consisting of 1,14-tetradecanediol di(meth)acrylate, 1,15-pentadecanediol di(meth)acrylate, 1,16-hexadecanediol di(meth)acrylate, 1,17-heptadecanediol di(meth)acrylate, and 1,18-octadecanediol di(meth)acrylate, but is not necessarily limited thereto. A weight average molecular weight of the monomer represented by Chemical Formula 1 preferably ranges from 500 to 3000.

In addition, the monomer represented by Chemical Formula 2 may be one or more selected from the group consisting of isotetradecyl (meth)acrylate, isopentadecyl (meth)acrylate, isohexadecyl (meth)acrylate, isoheptadecyl (meth)acrylate, and isooctadecyl (meth)acrylate, but is not necessarily limited thereto.

The monomer represented by Chemical Formula 3 may be one or more selected from the group consisting of poly-1-pentene, poly-1-hexene, poly-1-heptene, poly-1-octene, poly-1-notene, poly-1-decene, poly-1-undecene, poly-1-dodecene, poly-1-tridecene, poly-1-tetradecene, and poly-1-hexadodecene, but is not necessarily limited thereto.

The photocurable monomer according to the present invention may further include one or more monomers selected from the group consisting of compounds represented by the following Chemical Formulas 4 to 6.

[Chemical Formula 4] R₅-A-R₆

[Chemical Formula 5] R₇-B

[Chemical Formula 6] R₈-L-O-Ar₁

in Chemical Formulas 4 to 6,
R₅ to R₈ are, each independently, a (meth)acryloyl group, A is a substituted or unsubstituted C₉₋₂₀ cycloalkylene group forming two bridged junction rings, B is a substituted or unsubstituted C₆₋₁₂ bridged cycloalkyl group, L is a direct bond or a C₁₋₁₀ alkylene group, and Ar1 is a C₆₋₆₀ aryl group.

The monomer represented by Chemical Formula 4 may be a compound (tricyclodecanedimethanol diacrylate (TCDDA)) represented by the following Chemical Formula 7, but is not necessarily limited thereto.

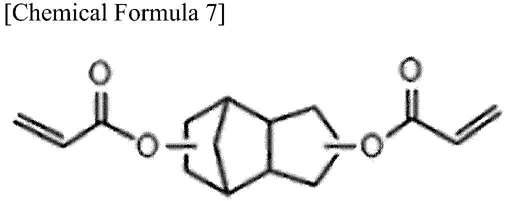

The monomer represented by Chemical Formula 5 may be a compound (isobornyl acrylate (IBOMA)) represented by the following Chemical Formula 8, but is not necessarily limited thereto.

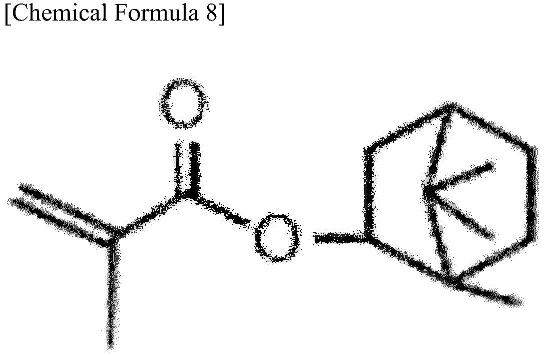

The monomer represented by Chemical Formula 6 may be a monomer selected from the group consisting of the following Chemical Formulas A-1 to A-3, but is not necessarily limited thereto.

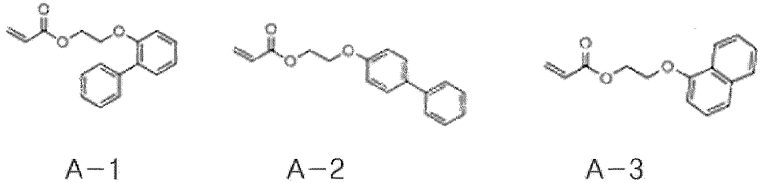

The photocurable monomer is preferably included in an amount of 20 to 99 wt% based on the total weight of the photocurable monomer.

More specifically, the monomer represented by Chemical Formula 1 may be included in an amount of 15 to 60 wt%, the (meth)acrylate represented by Chemical Formula 2 may be included in an amount of 30 to 70 wt%, the monomer represented by Chemical Formula 3 may be included in an amount of 1 to 25 wt%, and the monomers represented by Chemical Formulas 4 to 6 may be included in an amount of 1 to 35 wt% based on the total weight of the composition.

The composition for encapsulating an organic light-emitting element according to the present invention includes a photopolymerization initiator capable of curing the photocurable monomer through UV irradiation, etc. The photopolymerization initiator is not particularly limited as long as it is a typical photopolymerization initiator capable of performing a photocurable reaction. For example, the photopolymerization initiator may include a triazine-based, acetophenone-based, benzophenone-based, thioxanthone-based, benzoin-based, phosphorus-based, and oxime-based materials, or a mixture thereof.

The triazine-based material may include 2,4,6-trichloro-s-triazine, 2-phenyl-4,6-bis(trichloromethyl)-s-triazine, 2-(3',4'-dimethoxy styryl)-4,6-bis(trichloromethyl)-s-triazine, 2-(4'-methoxy naphthyl)-4,6-bis(trichloromethyl)-s-triazine, 2-(p-methoxy phenyl)-4,6-bis(trichloromethyl)-s-triazine, 2-(p-tolyl)-4,6-bis(trichloromethyl)-s-triazine, 2-biphenyl-4,6-bis(trichloromethyl)-s-triazine, bis(trichloromethyl)-6-styryl-s-triazine, 2-(naphtho-1-yl)-4,6-bis(trichloromethyl)-s-triazine, 2-(4-methoxy naphtho-1-yl)-4,6-bis(trichloromethyl)-s-triazine, 2,4-trichloromethyl(piperonyl)-6-triazine, 2,4-(trichloromethyl(4'-methoxy styryl)-6-triazine, or a mixture thereof.

The acetophenone-based material may include 2,2'-diethoxy acetophenone, 2,2'-dibuthoxy acetophenone, 2-hydroxy-2-methyl propiophenone, pt-butyl trichloro acetophenone, p-t-butyl dichloro acetophenone, 4-chloro acetophenone, 2,2'-dichloro-4-phenoxy acetophenone, 2-methyl-1-(4-(methylthio)phenyl)-2-morpholino propan-1-one, 2-benzyl-2-dimethyl amino-1-(4-morpholino phenyl)-butan-1-one, or a mixture thereof.

The benzophenone-based material may include benzophenone, benzoyl benzoic acid, methyl benzoic acid, 4-phenyl benzophenone, hydroxy benzophenone, acrylated benzophenone, 4,4'-bis(dimethyl amino)benzophenone, 4,4'-dichloro benzophenone, 3,3'-dimethyl-2-methoxy benzophenone, or a mixture thereof.

The thioxanthone-based material may include thioxanthone, 2-methyl thioxanthone, isopropyl thioxanthone, 2,4-diethyl thioxanthone, 2,4-diisopropyl thioxanthone, 2-chloro thioxanthone, or a mixture thereof.

The benzoin-based material may include benzoin, benzoin methyl ether, benzoin ethyl ether, benzoin isopropyl ether, benzoin isobutyl ether, benzyl dimethyl ketal, or a mixture thereof.

The phosphorus-based material may include bisbenzoylphenyl phosphine oxide, benzoyldiphenyl phosphine oxide, or a mixture thereof.

The oxime-based material may include 2-(o-benzoyloxime)-1-[4-(phenylthio)phenyl]-1,2-octanedione and 1-(o-acetyloxime)-1-[9-ethyl-6-(2-methylbenzoyl)-9H-carbazol-3-yl]ethanone, or a mixture thereof.

The photopolymerization initiator is preferably included in an amount of 0.1 to 10 wt% based on the total weight of the composition, and this is because, when the photopolymerization initiator is included in the content range, photopolymerization can occur sufficiently during exposure, and the generation of outgassing and the degradation of reliability due to the unreacted initiator remaining after photopolymerization can be prevented.

The composition for encapsulating an organic light-emitting element according to the present invention may further include one or more additives selected from the group consisting of a surfactant, a curing accelerator, and an antioxidant. In particular, the surfactant is advantageous in inducing dispersion of the composition.

Since the composition for encapsulating an organic light-emitting element according to the present invention has low dielectric constant characteristics in which a dielectric constant is 2.60 or less at a frequency in the range of 100 kHz to 1 MHz, the composition has superior touch sensitivity when the composition for encapsulation is applied to a touch panel.

In addition, the composition for encapsulating an organic light-emitting element according to the present invention preferably has a viscosity of 10 to 20 cPs, and it is because the processability of the composition can be further improved in the above range of the viscosity.

Another organic light-emitting diode display device according to the present invention includes an encapsulation part containing the composition for encapsulating an organic light-emitting element.

FIG. 1 is an exemplary view of an organic light-emitting diode display device according to one embodiment of the present invention. The organic light-emitting diode display device illustrated in FIG. 1 includes a substrate 100, an organic light-emitting element 200 disposed on the substrate 100, and an encapsulation part 300 disposed on the organic light-emitting element 200. In this case, the encapsulation part 300 is formed as multiple layers composed of a first encapsulation layer 310 and a second encapsulation layer 320, but the present invention may include a configuration in which the encapsulation part 300 is formed in two or more layers. When the encapsulation part 300 is formed in two layers of multiple layers, the encapsulation part 300 may include an inorganic barrier layer and an organic barrier layer. For example, when the first encapsulation layer 310 is an inorganic barrier layer, the second encapsulation layer 320 may be an organic barrier layer, but the stacking order is not limited thereto.

The encapsulation part 300 may be formed as an organic barrier layer to encapsulate or encapsulate an organic light-emitting diode display device, and the organic barrier layer may be formed by photocuring the composition for encapsulating an organic light-emitting element according to the present invention.

The composition for encapsulation (a material for an organic barrier layer) may be coated by an inkjet, vacuum deposition, spin coating, or slit coating method, and an initiator may be used during photocuring.

Hereinafter, the present invention will be described in detail using the composition for encapsulating an organic light-emitting element according to the present invention as an example, but is not limited to the following example.

### [Examples]

The compositions for encapsulating an organic light-emitting element of Examples 1 to 4 were prepared by mixing the photocurable monomer and photoinitiator (BAPO) stated in Table 1 below in a weight ratio.

Then, the prepared compositions were stirred for 12 hours and filtered by a PTFE filter (pore size: 0.45 µm).

The filtered compositions for encapsulating an organic light-emitting element were spin-coated to form a thickness of 8.0 µm or more, and then irradiated using a UV exposure device at a light intensity of 1 J to form an encapsulation film. The dielectric constant and viscosity were measured using the following methods.

Dielectric constant: a lower electrode was coated with the compositions for encapsulating an organic light-emitting element in a thickness of 8.0 µm or more and cured. Then, an upper electrode Ag was deposited in a thickness of 1,000 Å. The dielectric constants of the prepared samples were measured and then calculated by E4980A from KEYSIGHT.

Viscosity: the viscosity of liquid compositions for encapsulating an organic light-emitting element were measured using a rotational viscometer.

As a result, all dielectric constants of encapsulation films formed of the compositions for encapsulating an organic light-emitting element in Examples 1 to 4 according to the present invention were obtained as values of 2.60 F/m or less. Accordingly, it was confirmed that the touch panel to which the encapsulation film manufactured according to the present invention was applied could obtain superior touch sensitivity.

**[Table 1]**

| No. | | Photocurable monomer | | | | | Photoiniti ator | Dielect ric consta nt | Visco sity | Surface tension | Transmit tance |
|---|---|---|---|---|---|---|---|---|---|---|---|
| | | TDMA | TCD DA | IBO MA | ISTA | PDC | (BAPO) | | | | |
| | | Parts by weight | | | | | Parts by weight | [F/m] | [cPs] | [mN/m] | [%] |
| Exa mple | 1 | 25 | 10 | 5 | 59.95 | 1 | 1 | 2.51 | 19.5 | 28.5 | 99.5 |
| | 2 | 25 | 10 | 5 | 59 | 5 | 1 | 2.45 | 19.6 | 28.8 | 99.5 |
| | 3 | 25 | 10 | 5 | 58.5 | 10 | 1 | 2.41 | 19.6 | 28.5 | 99.5 |
| | 4 | 25 | 10 | 5 | 58 | 15 | 1 | 2.38 | 19.6 | 28.6 | 99.5 |

| | | | | | | | | | | | |
|---|---|---|---|---|---|---|---|---|---|---|---|
| TDMA: 1,14-tetradecanediol dimethacrylate (CAS : 168473-14-1) TCDDA : tricyclodecanedimethanol diacrylate (CAS : 42594-17-2) IBOMA : isobornyl acrylate (CAS : 5888-33-5) ISTA: isooctadecyl acrylate (CAS : 93841-48-6) PDC : Poly 1-Decene (CAS : 68037-01-4) BAPO : Bis(2,4,6-trimethylbenzoyl)-phenylphosphineoxide (CAS : 162881-26-7) | | | | | | | | | | | |

The above description is merely an example of the present invention, and those skilled in the art will be able to carry out various modifications without departing from the essential characteristics of the present invention. Accordingly, the embodiments disclosed in the present specification are not intended to limit the present invention, but to describe the present invention, and the spirit and scope of the present invention are not limited by these embodiments. The scope of the present invention should be construed by the appended claims, and all technologies within the equivalent scope should be construed as being included in the scope of the present invention.

### [DESCRIPTION OF REFERENCE NUMERALS]

100: substrate
200: organic light-emitting diode
300: encapsulation part
310: first encapsulation part
320: second encapsulation part

## Claims

1. A composition for encapsulating an organic light-emitting element, comprising:
a photocurable monomer including all of monomers represented by the following Chemical Formulas 1 to 3; and a photopolymerization initiator,
wherein a dielectric constant is 2.65 or less at a frequency in a range of 100 kHz to 1 MHz, 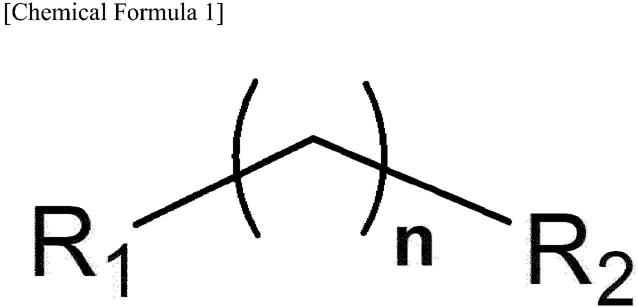 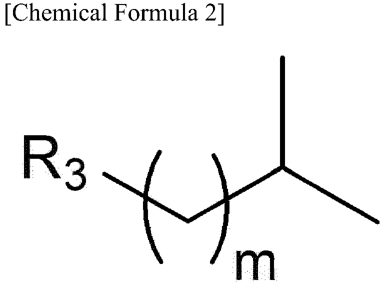 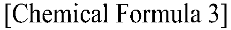 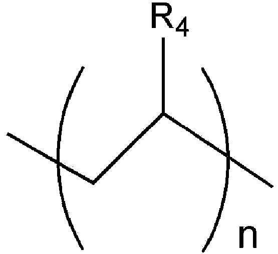 in Chemical Formulas 1 to 3,
R₁ to R₃ are, each independently, a (meth)acryloyl group,
R₄ is a substituted or unsubstituted C₁₋₂₀ alkyl group,
m ranges from 5 to 15, and
n ranges from 1 or 10.

2. The composition of claim 1, wherein the photocurable monomer further includes one or more monomers selected from the group consisting of compounds represented by the following Chemical Formulas 4 to 6,
[Chemical Formula 4] R₅-A-R₆
[Chemical Formula 5] R₇-B
[Chemical Formula 6] R₈-L-O-Ar₁
in Chemical Formulas 4 to 6,
R₅ to R₈ are, each independently, a (meth)acryloyl group,
A is a substituted or unsubstituted C₉-₂₀ cycloalkylene group forming two bridged junction rings,
B is a substituted or unsubstituted C₆₋₁₂ bridged cycloalkyl group,
L is a direct bond or a C₁₋₁₀ alkylene group, and
Ar1 is a C₆₋₆₀ aryl group.

3. The composition of claim 2, wherein the photocurable monomer is included in an amount of 20 to 99 wt% based on the total weight of the photocurable monomer.

4. The composition of claim 1, wherein the monomer represented by Chemical Formula 1 is one or more selected from the group consisting of 1,14-tetradecanediol di(meth)acrylate, 1,15-pentadecanediol di(meth)acrylate, 1,16-hexadecanediol di(meth)acrylate, 1,17-heptadecanediol di(meth)acrylate, and 1,18-octadecanediol di(meth)acrylate.

5. The composition of claim 1, wherein the monomer represented by Chemical Formula 2 is one or more selected from the group consisting of isotetradecyl (meth)acrylate, isopentadecyl (meth)acrylate, isohexadecyl (meth)acrylate, isoheptadecyl (meth)acrylate, and isooctadecyl (meth)acrylate.

6. The composition of claim 1, wherein the monomer represented by Chemical Formula 3 is one or more selected from the group consisting of poly-1-pentene, poly-1-hexene, poly-1-heptene, poly-1-octene, poly-1-notene, poly-1-decene, poly-1-undecene, poly-1-dodecene, poly-1-tridecene, poly-1-tetradecene, and poly-1-hexadodecene.

7. The composition of claim 1, wherein the photocurable monomer represented by Chemical Formula 4 is a compound represented by the following Chemical Formula 7,

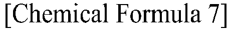

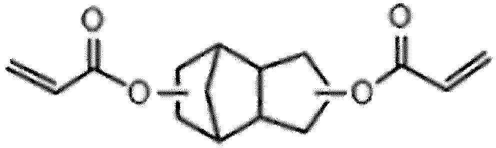

8. The composition of claim 1, wherein the photocurable monomer represented by Chemical Formula 5 is a compound represented by the following Chemical Formula 8,

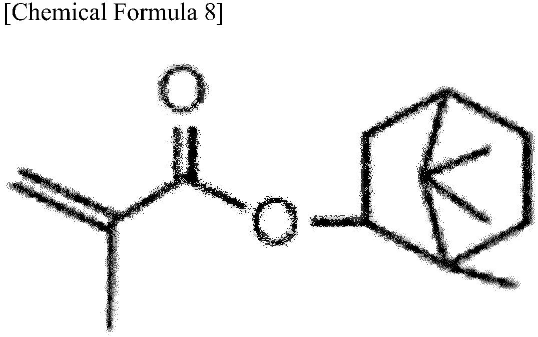

9. The composition of claim 1, wherein the monomer represented by Chemical Formula 6 is a monomer selected from the group consisting of the following Chemical Formulas A-1 to A-3.

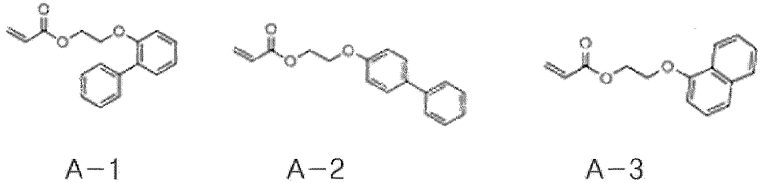

10. The composition of claim 1, wherein the photopolymerization initiator is one or more selected from the group consisting of triazine-based, acetophenone-based, benzophenone-based, thioxanthone-based, benzoin-based, phosphorus-based, and oxime-based materials, and a mixture thereof.

11. The composition of claim 1, wherein the photopolymerization initiator is included in an amount of 0.1 to 10 wt% based on the total weight of the composition.

12. The composition of claim 1, further comprising one or more additives selected from the group consisting of a surfactant, a curing accelerator, and an antioxidant.

13. An organic light-emitting diode display device comprising an encapsulation film containing the composition for encapsulating an organic light-emitting element according to any one of claims 1 to 12.
